# EUROPEAN PATENT SPECIFICATION

(11) **EP 3 343 162 B1**
(45) Date of publication and mention of the grant of the patent: **03.03.2021**
(21) Application number: 17178032.3
(22) Date of filing: 27.06.2017
(51) Int. Cl.: F28F 3/02, F28F 3/06, F28D 15/02

(54) **HEAT DISSIPATION APPARATUS**
WÄRMEABLEITUNGSVORRICHTUNG
APPAREIL DE DISSIPATION THERMIQUE

(30) Priority: 03.01.2017 US 201715397437
(43) Date of publication of application: 04.07.2018
(73) Proprietor: Quanta Computer Inc., Taoyuan City 333 (TW)
(72) Inventor: CHEN, Chao-Jung, Taoyuan City (TW); HUANG, Yu-Nien, Taoyuan City (TW); CHEN, Ching-Yu, Taoyuan City (TW); LI, Tsung-Ta, Taoyuan City (TW)
(74) Representative: D Young & Co LLP

(56) References cited:
- WO-A1-2013/169033
- US-A- 5 567 986
- US-A1- 2004 052 051
- US-A1- 2008 121 372
- US-A1- 2009 016 023
- US-A1- 2010 078 153
- US-A1- 2013 175 021
- US-B1- 6 945 319
- US-B2- 7 854 255

## Description

### FIELD

The subject matter herein generally relates to a heat dissipation apparatus. More specifically, the subject matter herein relates to a heat dissipation device having a portion extending away from the base.

### BACKGROUND

Heat sinks, or heat dissipation apparatus, are commonly used with electronic devices to improve heat dissipation and/or heat rejection thereby increasing performance of the associated electronic devices. Heat sinks utilize fin arrays and/or an airflow across the fin array to increase the exposed surface area for rejecting heat from the electronic device to the environment. A heat dissipation apparatus can include a heat pipe and/or a vapor chamber within the base to abuttingly engage the electronic device to extract increase heat transfer away from the electronic device to the fin array. However, the base in such devices typically provides a limited surface area for implementing a heat pipe or vapor chamber. US 2004/0052051 A1 discloses a heat sink that includes at least one heat pipe attached to a base having a substantially flat region for interfacing with an electronic component. Additionally, the heat sink comprises fins attached to the base and at least one heat pipe. Such a heat sink can dissipate heat from one or more electronic components more efficiently as the heat pipe coupled with the fins attached to the base provides alternate heat transfer paths for the heat generated by electronic components. US 2010/078153 A1 discloses a vapor augmented heatsink with multi-wick structure. US 5567986 A1 discloses a heat sink. US 7854255 B2 discloses a heat exchanger.

### SUMMARY

A heat dissipation apparatus is provided having a base, a heat dissipater, and a plurality of fin arrays. The heat dissipater has at least one horizontal portion disposed in the base and at least one vertical portion extending therefrom. At least one of the plurality of fin arrays coupled with the at least one horizontal portion of the heat dissipater and at least one of the plurality of fin arrays coupled with the at least one vertical portion extending from the base of the heat dissipater.

According to the invention, the heat dissipater has two folded plates coupled one to the other by soldering or diffusion bonding, and vertical bars extending from edges of one of the two folded plates to the other of the two folded plates, the vertical bars and the two folded plates collectively forming a single three-dimensional inner vapor chamber divided into a horizontal vapor chamber area and at least one vertical vapor chamber area coupled together, wherein the horizontal vapor chamber area is within the horizontal portion, and the at least one vertical vapor chamber area is within the vertical portion.

The at least one portion extending from the heat dissipater can be two vertically extending portions. The two vertically extending portions can be evenly spaced along the base and form a substantially twin "T" shape. The at least one portion extending from the heat dissipater can alternatively be three vertically extending portions.

The at least one fin array coupled to with the at least one horizontal portion can extend substantially perpendicular to the horizontal portion and the at least one fin array coupled with the at least one portion extending from the base can extend substantially perpendicular to the extending portion.

The at least one fin array coupled to with the at least one horizontal portion can radially extend relative to the horizontal portion and the at least one fin array coupled with the at least one extending portion can radially extend relative to the vertical portion.

Further particular and preferred aspects of the present invention are set out in the accompanying independent and dependent claims. Features of the dependent claims may be combined with features of the independent claims as appropriate.

### BRIEF DESCRIPTION OF THE DRAWINGS

Implementations of the present technology will now be described, by way of example only, with reference to the attached figures, wherein:
FIG. 1 is an isometric view of an embodiment of a heat dissipation apparatus in accordance with the present invention;
FIG. 2 is an isometric view of an example of a heat pipe heat dissipation apparatus, not part of the present invention;
FIG. 3 is an isometric view of an embodiment of a vapor chamber heat dissipation apparatus in accordance with the present invention;
FIG. 4 is an exploded view of an embodiment of a vapor chamber heat dissipation apparatus in accordance with the present invention; and
FIG. 5 is a side view of an embodiment of a heat dissipation apparatus in accordance with the present invention.

### DETAILED DESCRIPTION

It will be appreciated that for simplicity and clarity of illustration, where appropriate, reference numerals have been repeated among the different figures to indicate corresponding or analogous elements. In addition, numerous specific details are set forth in order to provide a thorough understanding of the embodiments described herein. However, it will be understood by those of ordinary skill in the art that the embodiments described herein can be practiced without these specific details. In other instances, methods, procedures and components have not been described in detail so as not to obscure the related relevant feature being described. The drawings are not necessarily to scale and the proportions of certain parts may be exaggerated to better illustrate details and features. The description is not to be considered as limiting the scope of the embodiments described herein.

Several definitions that apply throughout this disclosure will now be presented.

The term "coupled" is defined as connected, whether directly or indirectly through intervening components, and is not necessarily limited to physical connections. The connection can be such that the objects are permanently connected or releasably connected. The term "substantially" is defined to be essentially conforming to the particular dimension, shape or other word that substantially modifies, such that the component need not be exact. For example, substantially cylindrical means that the object resembles a cylinder, but can have one or more deviations from a true cylinder. The term "comprising" means "including, but not necessarily limited to"; it specifically indicates open-ended inclusion or membership in a so-described combination, group, series and the like.

The present disclosure relates to a heat dissipation apparatus according to claim 1.

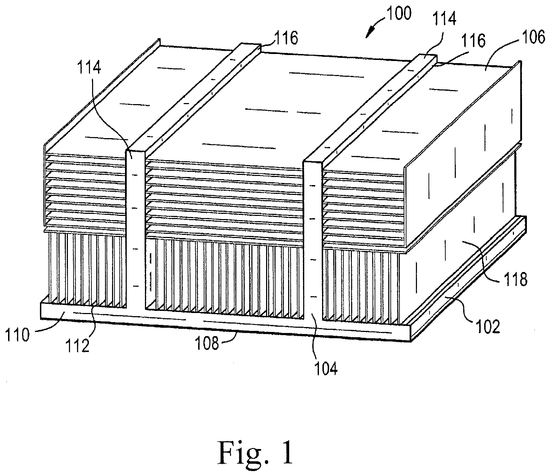

FIG. 1 illustrates a heat dissipation apparatus 100. The heat dissipation apparatus 100 has a base 102, a heat dissipater 104 and a plurality of fin arrays 106. The heat dissipation apparatus 100 can have a base 102 configured to receive at least a portion of the heat dissipater 104 therein. The base 102 can have a bottom surface 108 configured to abuttingly engage a heat source (not shown). The heat source can be an electronic device, such as a computer processing unit (CPU), microcontroller, graphic processing unit (GPU), or other heat generating device. The bottom surface 108 can expose at least a portion of the heat dissipater 104 to the heat source and provide an abutting engagement between at least a portion of the heat dissipater 104 and the heat source. The base 102 can be formed from a thermally conductive material such as copper or aluminum to increase thermal heat conductive form the heat source to the heat dissipater 104.

The heat dissipater 104 has at least one horizontal portion 110 having an upper surface 112 and at least one vertical portion 114 extending away therefrom. The upper surface 112 is coupled with one or more of the plurality of fin arrays 106. The at least one vertical portion 114 has an exterior surface 116 and the exterior surface 116 is coupled with one or more of the plurality of fin arrays 106. The at least one horizontal portion 110 is disposed in the base 102 and configured to be at least partially exposed to the heat source via the bottom surface 108 of the base 102. The heat dissipater 104 can be formed of any thermally conductive material including, but not limited to copper, aluminum, or a combination thereof.

The plurality of fin arrays 106 are coupled with the heat dissipater 104 and increase the rejection of thermal energy from the heat source to the environment. At least one of the plurality of fin arrays 106 is coupled with the base 102, the at least one horizontal portion 110 of the heat dissipater 104, and/or the at least one vertical portion 114. The heat dissipater 104 having the horizontal portion 110 and the vertical portion 114 can reduce the overall length of each fin within a fin array 106, thus increasing the efficiency of the plurality of fin arrays 106 while maintaining the surface area of the plurality of fin arrays 106.

The plurality of fin arrays 106 can increase the exposed surface area of the heat dissipater 104, thereby improving the rejection of thermal energy transferred from the heat source to the heat dissipater 104.

The heat dissipation apparatus 100 can be implemented with a fan (not shown) generating an air flow across the plurality of fin arrays 106, thereby increasing heat transfer from the plurality of fin arrays 106 to the environment. Fan power requirements can be determined by the arrangement of the heat dissipation apparatus 100 and the pressure drop (Δp) associated with airflow across the heat dissipation apparatus 100. Fin thickness of the plurality of fin arrays 106 and arrangement and orientation of the plurality of fin arrays can alter the associated pressure drop and thus alter the fan power requirements for the heat dissipation apparatus.

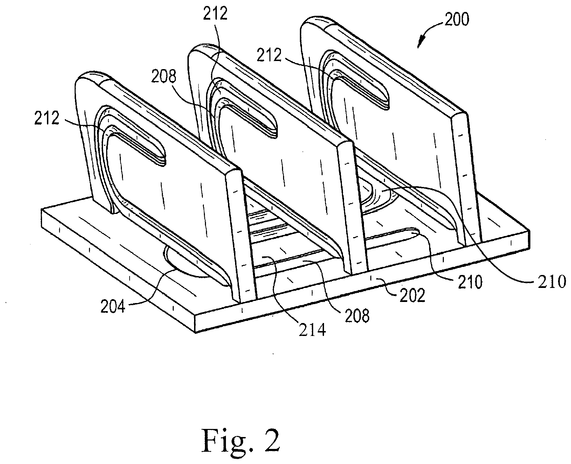

FIG. 2 illustrates an example of a heat dissipation apparatus 200. The heat dissipation apparatus 200 includes base 202 and a heat dissipater 204. The base 202 can have at least a portion of the heat dissipater 204 disposed therein. The head dissipater 204 is one or more heat pipes 208. The heat dissipater 204 can include at least one horizontal heat pipe 210 disposed in the base and at least one heat pipe 212 extending away therefrom. While the illustrated example shows the at least one heat pipe 212 extending away from the base 202 in a substantially vertical arrangement, it is within the scope of this disclosure to vary the angle at which the at least one heat pipe 212 extends away from the base 202. In some instances, the at least one heat pipe 212 can extend away from the base at an angle between 15 degrees and 75 degrees.

The heat pipe 208 can be a substantially circular tube having opposing ends. The heat pipe 208 is vacuum sealed tube having a working fluid disposed therein. As the working fluid absorbs thermal energy it boils to a vapor and travels from one end to the opposing end where it condenses back to a liquid, thus transferring the heat away from the one end and to the opposing end. The heat pipe 208 can also include a wicking material configured to allow the condensed working fluid to transition back to the one end of the heat pipe 208. The one end of the heat pipe 208 is adjacent and/or engaged with the heat source and the opposing end is disposed away from the heat source. The heat transfer of the heat pipe 208 is along the length of the heat pipe 208 from one end to the other, thus unidirectional. The heat pipe 208 can be made of any highly thermally conductive material, including but not limited to, copper, aluminum, or an alloy thereof. In some instances, at least a portion of the base 202 is constructed of a similarly highly thermally conductive material.

As can be appreciated in FIG. 2, the base 202 has two horizontal heat pipes 210 disposed therein and three substantially vertical heat pipes 212 extending away therefrom. The three heat pipes 212 extending away therefrom are spaced apart on the base 202. The horizontal heat pipes 210 coupled with the three substantially vertical heat pipes 212 forms a substantially "tri-T" arrangement. In other instances, more or less than three substantially vertical heat pipes 212 can be implement to form other arrangements, for example two vertical heat pipes 212 forming a substantially "twin-T" arrangement.

Each of the two horizontal heat pipes 210 and the three vertical heat pipes 212 can have a curved, or substantially U-shape, maximizing total length of the heat pipes 208. The two horizontal heat pipes can be placed within the base such that one horizontal heat pipe 210 has an end within an inner portion 214 of the substantially U shape formed by the other horizontal heat pipe 210.

The heat dissipater 204 can have a plurality of fin arrays coupled to the one or more heat pipes 208. The plurality of fin arrays allows the one or more heat pipes 208 to efficiently dissipate the thermal energy absorbed by the one or more heat pipes 208 to the environment.

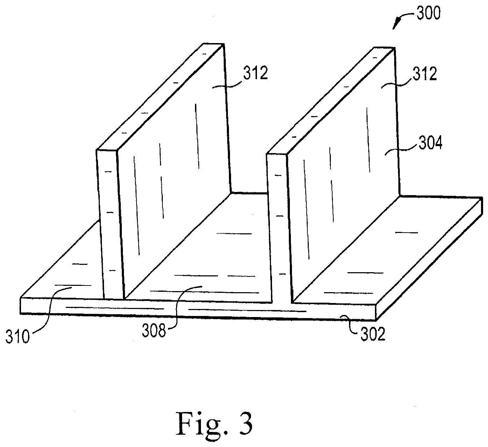

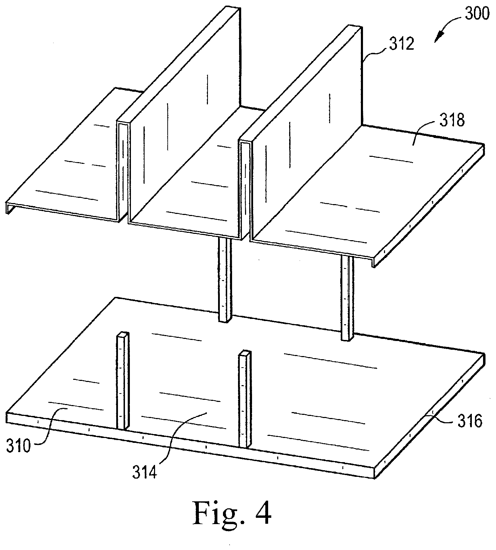

FIGS. 3 and 4 illustrate an embodiment of a heat dissipation apparatus 300. The heat dissipation apparatus 300 includes base 302 and a heat dissipater 304. The base 302 can have at least a portion of the heat dissipater 304 disposed therein. The head dissipater 304 can be one or more vapor chambers 308. The one or more vapor chambers 308 is integrally formed with the base 302. The heat dissipater 304 includes at least one horizontal vapor chamber 310 disposed in the base 302 and at least one vapor chamber 312 extending away therefrom. The at least one horizontal vapor chamber 310 and the at least one vapor chamber 312 are a single large vapor chamber having a substantially horizontal portion and portion extending away therefrom within a single vapor chamber 308.

As can be appreciated in FIGS. 3 and 4, the one or more vapor chambers 308 can be a vacuum sealed, substantially flat inner chamber 314 having a working fluid and wick material disposed therein. The vapor chamber 308 can abuttingly engage a heat source evaporating the working fluid and causing the gas to move within the inner chamber to a lower temperature causing the working fluid to condense and move within the wicking material back toward the heat source. The vapor chamber 308 allows heat transfer any direction within the vapor chamber 308, rather than directionally from one end to an opposing end. The vapor chamber 308 can be made of any highly thermally conductive material, including but not limited to, copper, aluminum, or an alloy thereof. In some instances, at least a portion of the base 302 is constructed of a similarly highly thermally conductive material.

As can further be appreciated in FIGS. 3 and 4, the base 302 has one horizontal vapor chamber 310 disposed therein and two substantially vertical vapor chambers 312 extending away therefrom. The two vapor chambers 312 extending away therefrom are spaced apart on the base 202 forming a substantially twin-T shaped arrangement. In other instances, more than two substantially vertical vapor chambers 312 can be implemented to form other arrangements, for example three vertical vapor chambers 312 forming a substantially tri-T arrangement.

As can be appreciated in FIG. 4, the heat dissipater 304 is formed from two folded plates 316, 318 coupled one to the other by soldering or diffusion bonding. In some instances, the two folded plates 316, 318 are formed from copper. The two folded plates 316, 318 form a single three-dimensional vapor chamber 308.

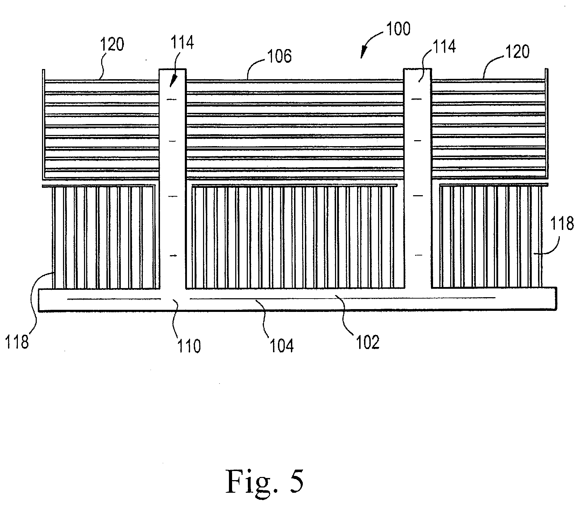

As discussed above with respect to FIG. 1 and discussed below in more detail with respect to FIG. 5, the heat dissipater 304 has a plurality of fin arrays coupled to the one or more vapor chambers 308. The plurality of fin arrays allows the one or more vapor chambers 308 to efficiently dissipate the thermal energy absorbed by the one or more vapor chambers 308 to the environment.

FIG. 5 illustrates a heat dissipation apparatus 100 having a plurality of fin arrays 106 coupled thereto. The plurality of fin arrays 106 is coupled with the base 102, the heat dissipater 104, the horizontal portion 110, the vertical portion 114, or any combination thereof.

As can be appreciated in FIG. 5, the plurality of fin arrays 106 can include three vertically extending fin arrays 118 coupled with the horizontal portion 110 and three horizontally extending fin arrays 120 coupled with the vertical portion 114. The vertically extending fin arrays 118 can transfer heat away from the horizontal portion 110 and transfer it to the environment and the horizontally extending fin arrays 120 can transfer heat away from the vertical portion 114 and transfer it to the environment. The plurality of fin arrays 106 can be made from a thermally conductive material similar to that of the heat dissipater 104, such as copper or aluminum.

While the illustrated embodiment details three vertically extending fin arrays 118 and three horizontally extending fin arrays 120, any number of fin arrays 106 can be implemented in a vertical or horizontal arrangement without deviating from the scope of the present disclosure. For example, the heat dissipation apparatus 100 can have two, four, five, six or any number of vertically extending fin arrays 118 in conjunction with two, four, five, six or any number of horizontally extending fin arrays 120.

Further, while the plurality of fin arrays 106 are detailed in a vertical or horizontal arrangement, the plurality of fin arrays 106 can be disposed at any angle relative to the respective heat dissipater 104. For example, each of the plurality of fin arrays 106 can radially extend away from the heat dissipater. In other instances, horizontal, vertical, and a radially extending fin arrays 106 can be implemented together depending on the configuration of the heat dissipater 104.
Although particular embodiments have been described herein, it will be appreciated that the invention is not limited thereto and that many modifications and additions thereto may be made within the scope of the claims. For example, various combinations of the features of the following dependent claims can be made with the features of the independent claim without departing from the scope of the present invention.

## Claims

1. A heat dissipation apparatus (100), comprising:
a base (102);
a heat dissipater (104, 304) having two folded plates (316, 318) coupled one to the other by soldering or diffusion bonding, and vertical bars extending from edges of one of the two folded plates (316) to the other of the two folded plates (316), the vertical bars and the two folded plates (316, 318) collectively forming a single three-dimensional inner vapor chamber (308) divided into a horizontal vapor chamber area (314) and at least one vertical vapor chamber area (312) coupled together, and the heat dissipater (304) comprising at least one horizontal portion (110) disposed in the base (102) and at least one vertical portion (114) extending therefrom, wherein the horizontal vapor chamber area (314) is within the horizontal portion (110), and the at least one vertical vapor chamber area (312) is within the vertical portion (114); and
a plurality of fin arrays (106), at least one fin array (106) coupled with the at least one horizontal portion (110) of the heat dissipater (104, 304) and at least one fin array (106) coupled with the at least one vertical portion (114) of the heat dissipater (104, 304).

2. The heat dissipation apparatus (100) of claim 1, **characterized in that** the at least one vertical portion (114) is two vertically extending portions.

3. The heat dissipation apparatus (100) of any of claims 1-2, **characterized in that** the at least one fin array (118) coupled with the at least one horizontal portion (110) of the heat dissipater (104, 304) is substantially perpendicular to the horizontal portion (110) and the at least one fin array (120) coupled with the at least one vertical portion (114) of the heat dissipater (104, 304) is substantially perpendicular to the vertical portion (114).

4. The heat dissipation apparatus (100) of any of claims 1-2, **characterized in that** the at least one fin array (106) coupled with the at least one horizontal portion (110) of the heat dissipater (104, 304) radially extends relative to the horizontal portion (110) and the at least one fin array (106) coupled with the at least one vertical portion (114) of the heat dissipater (104, 304) radially extends relative to the vertical portion (114).

5. The heat dissipation apparatus (100) of claim 2, **characterized in that** the at least two vertical portions (114) are evenly spaced along the base (102) forming a substantially twin "T" shape.

6. The heat dissipation apparatus (100) of claim 5, **characterized in that** the at least one fin array (118) coupled with the at least one horizontal portion (110) of the heat dissipater (104, 304) is substantially perpendicular to the horizontal portion (110) and the at least one fin array (120) coupled with the at least one vertical portion (114) of the heat dissipater (104, 304) is substantially perpendicular to the vertical portion (114).

7. The heat dissipation apparatus (100) of claim 5, wherein the at least one fin array (106) coupled with the at least one horizontal portion (110) of the heat dissipater (104, 304) radially extends relative to the horizontal portion (110) and the at least one fin array (106) coupled with the at least one vertical portion (114) of the heat dissipater (104, 304) radially extends relative to the vertical portion (114).

8. The heat dissipation apparatus (100) of claim 1, **characterized in that** the at least one horizontal portion (110) has an upper surface (112), the at least one vertical portion (114) is extending away from the upper surface (112), and the at least one fin array (106) is coupled with the vertical portion (114) away from the upper surface (112).

## Patentansprüche

1. Wärmeableitungsvorrichtung (100), die Folgendes umfasst:
eine Basis (102);
einen Wärmeabieiter (104, 304), der zwei gefaltete Platten (316, 318), die durch Löten oder Diffusionsbonden eine an die andere gekoppelt sind, und vertikale Stäbe, die sich von Kanten von einer der zwei gefalteten Platten (316) zur anderen der zwei gefalteten Platten (316) erstrecken, aufweist, wobei die vertikalen Stäbe und die zwei gefalteten Platten (316, 318) gemeinsam eine einzelne dreidimensionale Dampfkammer (308) bilden, die in einen horizontalen Dampfkammerbereich (314) und mindestens einen vertikalen Dampfkammerbereich (312), die zusammengekoppelt sind, geteilt ist, und wobei der Wärmeabieiter (304) mindestens einen horizontalen Abschnitt (110), der in der Basis (102) angeordnet ist, und mindestens einen vertikalen Abschnitt (114), der sich davon erstreckt, umfasst, wobei sich der horizontale Dampfkammerbereich (314) im horizontalen Abschnitt (110) befindet und sich der mindestens eine vertikale Dampfkammerbereich (312) im vertikalen Abschnitt (114) befindet; und
eine Vielzahl von Rippengruppen (106), wobei mindestens eine Rippengruppe (106) an den mindestens einen horizontalen Abschnitt (110) des Wärmeableiters (104, 304) gekoppelt ist und mindestens eine Rippengruppe (106) an den mindestens einen vertikalen Abschnitt (114) des Wärmeableiters (104, 304) gekoppelt ist.

2. Wärmeableitungsvorrichtung (100) nach Anspruch 1, **dadurch gekennzeichnet, dass** der mindestens eine vertikale Abschnitt (114) zwei sich vertikal erstreckende Abschnitte ist.

3. Wärmeableitungsvorrichtung (100) nach einem der Ansprüche 1-2, **dadurch gekennzeichnet, dass** die mindestens eine Rippengruppe (118), die an den mindestens einen horizontalen Abschnitt (110) des Wärmeableiters (104, 304) gekoppelt ist, im Wesentlichen senkrecht zum horizontalen Abschnitt (110) verläuft und die mindestens eine Rippengruppe (120), die an den mindestens einen vertikalen Abschnitt (114) des Wärmeableiters (104, 304) gekoppelt ist, im Wesentlichen senkrecht zum vertikalen Abschnitt (114) verläuft.

4. Wärmeableitungsvorrichtung (100) nach einem der Ansprüche 1-2, **dadurch gekennzeichnet, dass** sich die mindestens eine Rippengruppe (106), die an den mindestens einen horizontalen Abschnitt (110) des Wärmeableiters (104, 304) gekoppelt ist, relativ zum horizontalen Abschnitt (110) radial erstreckt und sich die mindestens eine Rippengruppe (106), die an den mindestens einen vertikalen Abschnitt (114) des Wärmeableiters (104, 304) gekoppelt ist, relativ zum vertikalen Abschnitt (114) radial erstreckt.

5. Wärmeableitungsvorrichtung (100) nach Anspruch 2, **dadurch gekennzeichnet, dass** die mindestens zwei vertikalen Abschnitte (114) entlang der Basis (102) gleichmäßig beabstandet sind und eine im Wesentlichen doppelte "T"-Form bilden.

6. Wärmeableitungsvorrichtung (100) nach Anspruch 5, **dadurch gekennzeichnet, dass** die mindestens eine Rippengruppe (118), die an den mindestens einen horizontalen Abschnitt (110) des Wärmeableiters (104, 304) gekoppelt ist, im Wesentlichen senkrecht zum horizontalen Abschnitt (110) verläuft und die mindestens eine Rippengruppe (120), die an den mindestens einen vertikalen Abschnitt (114) des Wärmeableiters (104, 304) gekoppelt ist, im Wesentlichen senkrecht zum vertikalen Abschnitt (114) verläuft.

7. Wärmeableitungsvorrichtung (100) nach Anspruch 5, wobei sich die mindestens eine Rippengruppe (106), die an den mindestens einen horizontalen Abschnitt (110) des Wärmeableiters (104, 304) gekoppelt ist, relativ zum horizontalen Abschnitt (110) radial erstreckt und sich die mindestens eine Rippengruppe (106), die an den mindestens einen vertikalen Abschnitt (114) des Wärmeableiters (104, 304) gekoppelt ist, relativ zum vertikalen Abschnitt (114) radial erstreckt.

8. Wärmeableitungsvorrichtung (100) nach Anspruch 1, **dadurch gekennzeichnet, dass** der mindestens eine horizontale Abschnitt (110) eine obere Fläche (112) aufweist, der mindestens eine vertikale Abschnitt (114) sich von der oberen Fläche (112) weg erstreckt und die mindestens eine Rippengruppe (106) an den vertikalen Abschnitt (114) von der oberen Fläche (112) weg gekoppelt ist.

## Revendications

1. Appareil de dissipation de chaleur (100), comprenant :
une base (102) ;
un dissipateur de chaleur (104, 304) possédant deux plaques pliées (316, 318) raccordées l'une à l'autre par soudage ou liaison par diffusion, et des barres verticales s'étendant depuis des bords d'une des deux plaques pliées (316) vers l'autre des deux plaques pliées (316), les barres verticales et les deux plaques pliées (316, 318) formant collectivement une chambre à vapeur interne tridimensionnelle unique (308) divisée en une zone de chambre à vapeur horizontale (314) et au moins une chambre à vapeur verticale (312) raccordées ensemble, et le dissipateur de chaleur (304) comprenant au moins une partie horizontale (110) disposée dans la base (102) et au moins une partie verticale (114) s'étendant depuis celle-ci, dans lequel la zone de chambre à vapeur horizontale (314) est à l'intérieur de la partie horizontale (110), et l'au moins une zone de chambre à vapeur verticale (312) est à l'intérieur de la partie verticale (114) ; et
une pluralité de réseaux d'ailettes (106), au moins un réseau d'ailettes (106) étant raccordé à l'au moins une partie horizontale (110) du dissipateur de chaleur (104, 304) et au moins un réseau d'ailettes (106) étant raccordé à l'au moins une partie verticale (114) du dissipateur de chaleur (104, 304).

2. Appareil de dissipation de chaleur (100) selon la revendication 1, **caractérisé en ce que** l'au moins une partie verticale (114) est deux parties s'étendant verticalement.

3. Appareil de dissipation de chaleur (100) selon l'une quelconque des revendications 1 et 2, **caractérisé en ce que** l'au moins un réseau d'ailettes (118) raccordé à l'au moins une partie horizontale (110) du dissipateur de chaleur (104, 304) est sensiblement perpendiculaire à la partie horizontale (110) et l'au moins un réseau d'ailettes (120) raccordé à l'au moins une partie verticale (114) du dissipateur de chaleur (104, 304) est sensiblement perpendiculaire à la partie verticale (114).

4. Appareil de dissipation de chaleur (100) selon l'une quelconque des revendications 1 et 2, **caractérisé en ce que** l'au moins un réseau d'ailettes (106) raccordé à l'au moins une partie horizontale (110) du dissipateur de chaleur (104, 304) s'étend radialement par rapport à la partie horizontale (110) et l'au moins un réseau d'ailettes (106) raccordé à l'au moins une partie verticale (114) du dissipateur de chaleur (104, 304) s'étend radialement par rapport à la partie verticale (114).

5. Appareil de dissipation de chaleur (100) selon la revendication 2, **caractérisé en ce que** les au moins deux parties verticales (114) sont espacées régulièrement le long de la base (102) en formant sensiblement un « T » double.

6. Appareil de dissipation de chaleur (100) selon la revendication 5, **caractérisé en ce que** l'au moins un réseau d'ailettes (118) raccordé à l'au moins une partie horizontale (110) du dissipateur de chaleur (104, 304) est sensiblement perpendiculaire à la partie horizontale (110) et l'au moins un réseau d'ailettes (120) raccordé à l'au moins une partie verticale (114) du dissipateur de chaleur (104, 304) est sensiblement perpendiculaire à la partie verticale (114).

7. Appareil de dissipation de chaleur (100) selon la revendication 5, dans lequel l'au moins un réseau d'ailettes (106) raccordé à l'au moins une partie horizontale (110) du dissipateur de chaleur (104, 304) s'étend radialement par rapport à la partie horizontale (110) et l'au moins un réseau d'ailettes (106) raccordé à l'au moins une partie verticale (114) du dissipateur de chaleur (104, 304) s'étend radialement par rapport à la partie verticale (114).

8. Appareil de dissipation de chaleur (100) selon la revendication 1, **caractérisé en ce que** l'au moins une partie horizontale (110) a une surface supérieure (112), l'au moins une partie verticale (114) s'étend à distance de la surface supérieure (112), et l'au moins un réseau d'ailettes (106) est raccordé à la partie verticale (114) à distance de la surface supérieure (112).
